# EUROPEAN PATENT APPLICATION

(11) **EP 4 565 020 A1**
(43) Date of publication of application: **04.06.2025**
(21) Application number: 23846874.8
(22) Date of filing: 11.07.2023
(51) Int. Cl.: H05K 7/20, H01L 23/367, F21V 29/76

(54) **HEAT SINK STRUCTURE AND MANUFACTURING METHOD THEREOF**

(30) Priority: 29.07.2022 KR 20220094977; 04.07.2023 KR 20230086285
(71) Applicant: KMW Inc., Hwaseong-si, Gyeonggi-do 18462 (KR)
(72) Inventor: KIM, Duk Yong, Yongin-si Gyeonggi-do 17086 (KR); LEE, Kang Hyun, Hwaseong-si Gyeonggi-do 18442 (KR); KIM, Dong Won, Bucheon-si Gyeonggi-do 14574 (KR); PARK, Won Jun, Yongin-si Gyeonggi-do 17134 (KR)
(74) Representative: Impuls legal PartG mbB
(86) International application number: PCT/KR2023/009823
(87) International publication number: WO 2024/025215

(57) **Abstract**

Provided are a heat sink and a manufacturing method thereof, wherein a heat sink body and a plurality of heat dissipation fins are each manufactured separately, and then the plurality of heat dissipation fins are fixed to the heat sink body by laser welding to form the plurality of heat dissipation fins in a plate shape that is thinner and longer than the heat sink body to provide a sufficient heat dissipation surface and thereby improve heat dissipation efficiency. To this end, the heat sink structure according to the present invention comprises: a heat sink body that has, on one side, a mounting surface on which a product from which heat is to be dissipated is located, and has, on the other side, a heat dissipation surface for dissipating heat; and a plurality of heat dissipation fins which are positioned upright on the heat dissipation surface of the heat sink body and coupled thereto by laser welding.

## Description

### [Technical Field]

The present disclosure relates to a heat sink structure and a method of manufacturing the same, and more particularly, to a heat sink structure in which heat dissipation fins have been bonded to a heat sink body by laser welding.

### [Background Art]

In general, a heat sink is installed in a product that requires the dissipation of heat, and can effectively discharge heat.

The heat sink is applied to various products in electronics, machinery, and automotive industries, such as LED lights, semiconductor manufacturing equipment, computers, medical equipment, and radioactive applications in order to prevent damage attributable to heat and allow a stable operation to be performed, and is modified in various forms suitable for products and applied to the products.

In general, the heat sink has a structure including multiple heat dissipation fins that stand upright on a side opposite to a mounting surface in a heat sink body having the mounting surface on which a product that requires the dissipation of heat is mounted, and rapidly discharges heat generated from the product through the exchange of heat between the heat dissipation fins and the air.

Korean Patent No. 10-0381303 (published on April 26, 2003) (hereinafter referred to as a "conventional technology") discloses a "porous heat sink".

The heat sink of the conventional technology is manufactured by extrusion or casting, and has a structure in which a heat dissipation plate, that is, a heat sink body, and multiple heat dissipation fins are integrated and formed.

However, the heat sink of the conventional technology is manufactured by extrusion or casting, and thus has the heat dissipation plate and the multiple heat dissipation fins integrated and formed therein. Accordingly, the heat sink has problems in that heat dissipation performance is limited and it is difficult to reduce weight because it is difficult to reduce the thickness of each of the multiple heat dissipation fins and an interval between the heat dissipation fins and thus the number of multiple heat dissipation fins formed is small.

Furthermore, the heat sink of the conventional technology is manufactured by extrusion or casting and thus has a mold complicatedly designed in order to form the multiple heat dissipation fins. For this reason, the heat sink has problems in that a high manufacturing cost is required, a lot of time is consumed for the design and manufacturing of a mold because the mold has to be separately manufactured in a form suitable for each product, and an error rate is high upon manufacturing.

In particular, the heat sink of the conventional technology is manufactured by extrusion or casting, and thus has a problem in that the heat dissipation efficiency is low because the heat dissipation fin cannot be formed thinly and lengthily compared to the heat sink body.

### [DISCLOSURE]

### [Technical Problem]

An object of the present disclosure is to provide a heat sink structure having improved heat dissipation efficiency by securing a sufficient heat dissipation surface in a way that after a heat sink body part and a plurality of heat dissipation fin parts are separately manufactured, the plurality of heat dissipation fin parts is fixed to the heat sink body part by laser welding so that each of the plurality of heat dissipation fin parts is formed in a plate shape that is thin and long compared to the heat sink body part, and a method of manufacturing the same.

Another object of the present disclosure is to provide a heat sink structure capable of minimizing the thickness of the heat dissipation fin and an interval between the heat dissipation fins and greatly reducing a manufacturing cost, by fixing the heat dissipation fins to the heat sink body by laser welding after the heat sink body and the heat dissipation fins are separately manufactured, and a method of manufacturing the same.

Technical objects of the present disclosure are not limited to the aforementioned objects, and the other objects not described above may be evidently understood from the following description by those skilled in the art.

### [Technical Solution]

In order to achieve the objects, a heat sink structure according to the present disclosure includes a heat sink body part and a plurality of heat dissipation fin parts. A mounting surface on which a product, that is, a heat dissipation target, is placed on one surface of the heat sink body part. A heat dissipation surface for discharging heat is provided on a surface different from the one surface of the heat sink body part. The plurality of heat dissipation fin parts stands upright on the heat dissipation surface of the heat sink body part and is coupled thereto by laser welding.

A plurality of welding coupling parts to which the plurality of heat dissipation fin parts is coupled by laser welding, respectively, may be formed in the heat dissipation surface of the heat sink body part in a way to protrude therefrom.

A welding coupling protrusion coupled to each of the plurality of welding coupling parts by laser welding may be formed at the bottom of each of the plurality of heat dissipation fin parts, The welding coupling protrusion may be formed to be thicker than the thickness of each of the plurality of heat dissipation fin parts.

Each of the plurality of welding coupling parts may be formed in round shapes in which both sides of a start stage of a part that belongs to each of the plurality of welding coupling parts and that protrudes from the heat dissipation surface of the heat sink body part are concave. Each of the plurality of welding coupling parts may be formed in round shapes in which both sides of an end in a protruding direction thereof are convex.

Each of the plurality of welding coupling parts may include a first heat dissipation fin support part. The first heat dissipation fin support part may be formed on the heat dissipation surface in a way to protrude therefrom. The welding coupling protrusion may stand upright on the heat dissipation surface on one side of the first heat dissipation fin support part. One side of the welding coupling protrusion may be coupled to one side of the first heat dissipation fin support part by laser welding.

Each of the plurality of welding coupling parts may include a first heat dissipation fin support part and a second heat dissipation fin support part. The welding coupling protrusion may be inserted between the first heat dissipation fin support part and the second heat dissipation fin support part, and may stand upright on the heat dissipation surface. At least one side of the welding coupling protrusion may be coupled to one side of at least one of the first heat dissipation fin support part and the second heat dissipation fin support part by laser welding.

Each of the plurality of welding coupling parts may include a support block part. The support block part may be formed on the heat dissipation surface in a way to protrude therefrom. The welding coupling protrusion may stand upright on the support block part. At least one side of the welding coupling protrusion may be coupled to the support block part by laser welding.

Each of the plurality of welding coupling parts may include a support block part, a first heat dissipation fin support part, and a second heat dissipation fin support part. The support block part may be formed on the heat dissipation surface in a way to protrude therefrom. The first heat dissipation fin support part may be formed at one end of the support block part thereon in a way to protrude therefrom.

The second heat dissipation fin support part may be formed at the other end of the support block part thereon in a way to protrude therefrom so that the second heat dissipation fin support part is spaced apart from the first heat dissipation fin support part. The welding coupling protrusion may be inserted between the first heat dissipation fin support part and the second heat dissipation fin support part, and may stand upright on the support block part. At least one side of the welding coupling protrusion may be coupled to one side of at least one of the first heat dissipation fin support part and the second heat dissipation fin support part by laser welding.

One side of the first heat dissipation fin support part and one side of the welding coupling protrusion may each be formed in a convex round shape.

One side of at least one of the first heat dissipation fin support part and the second heat dissipation fin support part and at least one side of the welding coupling protrusion may each be formed in a convex round shape.

At least one side of the welding coupling protrusion may be formed in a convex round shape.

The convex round shape may be a shape in which a laser is able to be radiated to each of the plurality of heat dissipation fin parts at an angle of 3 to 7° upon laser welding.

The thickness of the first heat dissipation fin support part may be formed to be 0.7 to 1.1 times the thickness of each of the plurality of heat dissipation fin parts. The height of the first heat dissipation fin support part may be formed to be 1 to 2 times the thickness of each of the plurality of heat dissipation fin parts.

Each of the thickness of the first heat dissipation fin support part and the thickness of the second heat dissipation fin support part may be formed to be 0.7 to 1.1 times the thickness of each of the plurality of heat dissipation fin parts. Each of the height of the first heat dissipation fin support part and the height of the second heat dissipation fin support part may be formed to be 1 to 2 times the thickness of each of the plurality of heat dissipation fin parts.

A minimum thickness of the support block part may be formed to be 2.4 to 3.3 times the thickness of each of the plurality of heat dissipation fin parts.

In order to achieve the objects, a method of manufacturing a heat sink structure according to the present disclosure includes a preparation step and a laser welding step. In the preparation step, a heat sink body part and a plurality of heat dissipation fin parts are separately manufactured. A mounting surface on which a product, that is, a heat dissipation target, is placed is provided on one surface of the heat sink body part. A heat dissipation surface for discharging heat is provided on a surface different from the one surface of the heat sink body part. A plurality of heat dissipation fin parts performs a heat dissipation action. In the laser welding step, the plurality of heat dissipation fin parts is fixed to the heat dissipation surface of the heat sink body part by laser welding so that the plurality of heat dissipation fin parts is spaced apart from each other.

In the preparation step, the heat sink body part may be manufactured by casting. The plurality of heat dissipation fin parts may be manufactured by cutting a metal plate that has been previously manufactured.

In the preparation step, a plurality of welding coupling parts may be formed in the heat dissipation surface of the heat sink body part in a way to protrude therefrom. In the preparation step, a welding coupling protrusion thicker than the thickness of each of the plurality of heat dissipation fin parts may be formed at the bottom of each of the plurality of heat dissipation fin parts. In the laser welding step, the welding coupling protrusion may be coupled to each of the plurality of welding coupling parts by laser welding.

The details of other embodiments are included in the detailed description and drawings.

### [Advantageous Effects]

The heat sink structure and the method of manufacturing the same according to the present disclosure have an effect in that heat dissipation efficiency is improved by securing a sufficient heat dissipation surface in a way that after the heat sink body part and the plurality of heat dissipation fin parts are separately manufactured, the plurality of heat dissipation fin parts is fixed to the heat sink body part by laser welding so that each of the plurality of heat dissipation fin parts is formed in a plate shape that is thin and long compared to the heat sink body part.

Furthermore, the heat sink structure and the method of manufacturing the same according to the present disclosure have effects in that the thickness of each of the plurality of heat dissipation fins and an interval between the heat dissipation fins are minimized and a manufacturing cost can be greatly reduced, by fixing the plurality of heat dissipation fins to the heat sink body by laser welding after the heat sink body and the plurality of heat dissipation fin are separately manufactured.

Effects of the present disclosure are not limited to the aforementioned effects, and the other effects not described above may be evidently understood by those skilled in the art from the claims.

### [Description of Drawings]

FIG. 1 is a perspective view illustrating a heat sink structure according to an embodiment of the present disclosure.
FIG. 2 is a rear perspective view of FIG. 1.
FIG. 3 is an exploded perspective view of FIG. 2 which is decomposed into a heat sink body part and a plurality of heat dissipation fins.
FIG. 4 is a partial enlarged view of FIG. 2.
FIG. 5 is a partial plan view of FIGS. 1 and 2.
FIG. 6 is a partial enlarged view of FIG. 5.
FIG. 7 is an exploded view of FIG. 6.
FIG. 8 is a diagram illustrating a heat sink structure according to another embodiment of the present disclosure.
FIG. 9 is a photo of a first test example in which the heat dissipation fin part is subjected to laser welding in a method of manufacturing a heat sink structure according to the present disclosure.
FIG. 10 is a photo of a second test example in which the heat dissipation fin part is subjected to laser welding in a method of manufacturing a heat sink structure according to the present disclosure.

### <Description of Reference Numerals >

100: heat sink body part 101: mounting surface
102: heat dissipation surface 105: accommodation space
107: welding coupling part 110: first heat dissipation fin support part
120: second heat dissipation fin support part 130: support block part
200: heat dissipation fin part 210: welding coupling protrusion

### [Best Mode]

Hereinafter, a heat sink structure and a method of manufacturing the same according to an embodiment of the present disclosure are described with reference to the drawings.

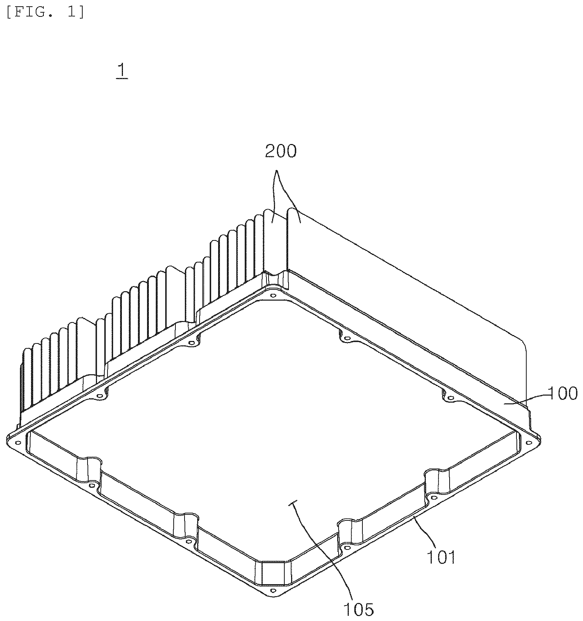

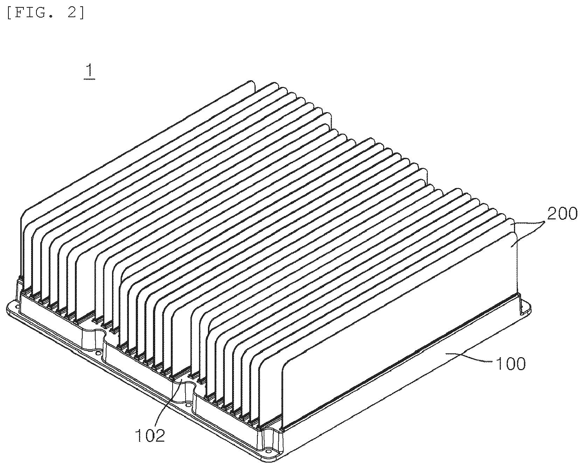

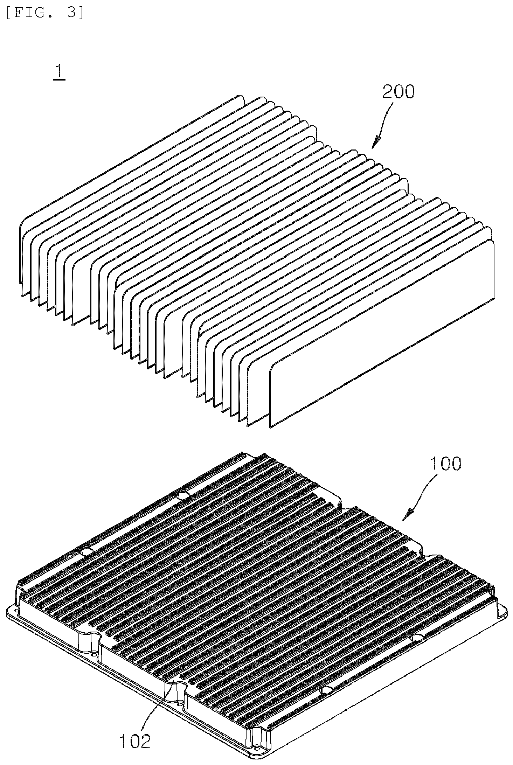

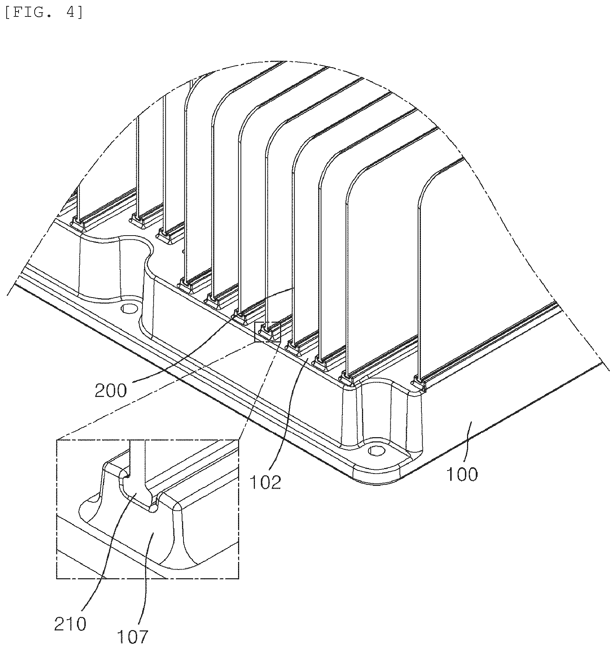

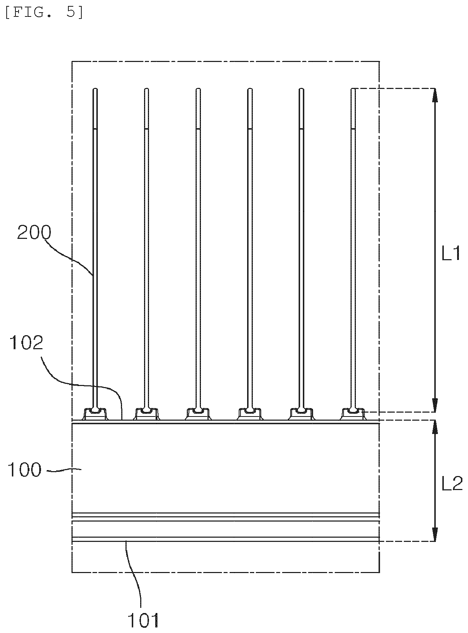

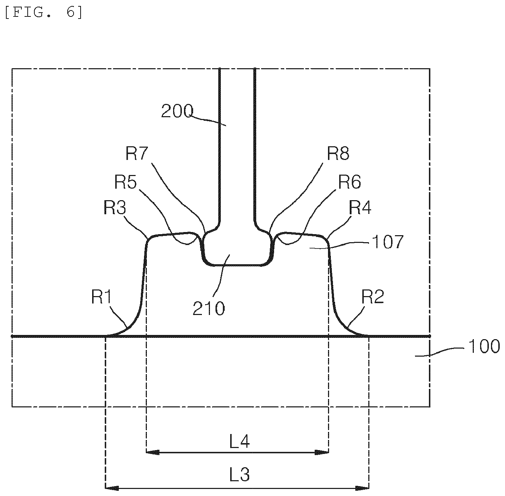

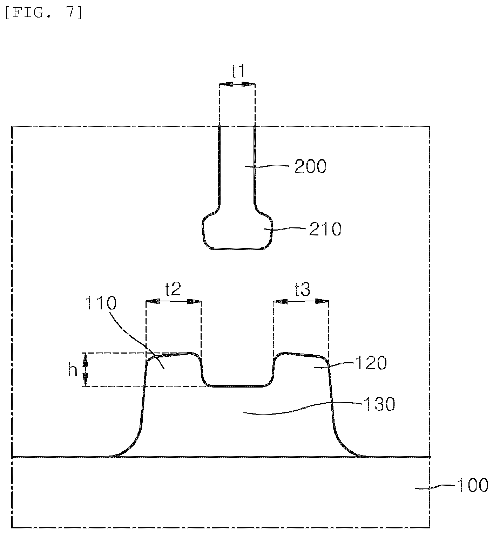

FIG. 1 is a perspective view illustrating a heat sink structure according to an embodiment of the present disclosure. FIG. 2 is a rear perspective view of FIG. 1. FIG. 3 is an exploded perspective view of FIG. 2 which is decomposed into a heat sink body part and a plurality of heat dissipation fins. FIG. 4 is a partial enlarged view of FIG. 2. FIG. 5 is a partial plan view of FIGS. 1 and 2. FIG. 6 is a partial enlarged view of FIG. 5. FIG. 7 is an exploded view of FIG. 6.

Referring to FIGS. 1 to 7, a heat sink structure 1 according to an embodiment of the present disclosure may include a heat sink body part 100 and a plurality of heat dissipation fin parts 200.

The heat sink structure according to an embodiment of the present disclosure may be manufactured by manufacturing the heat sink body part 100 by casting, manufacturing the plurality of heat dissipation fin parts 200 separately from the heat sink body part 100, and coupling the plurality of heat dissipation fin parts 200 to the heat sink body part 100 by laser welding.

A mounting surface 101 on which a product, that is, a heat dissipation target, is placed may be provided on one surface of the heat sink body part 100. In this case, the product may include an electronic part that generates predetermined heat as the electronic part is driven by power supplied thereto. That is, the product may be a printed circuit board on which Rx and Tx elements that are responsible for the output and transmission of signals in an antenna apparatus are mounted, and may be an inclusion body in which the printed circuit board is accommodated.

Accordingly, an accommodation space 105 in which the product is accommodated may be formed in the mounting surface 101 of the heat sink body part 100. However, the accommodation space 105 does not need to be essentially formed. In this case, the heat sink body part 100 may be formed in a plate form. The product may be disposed on the mounting surface 101 of the heat sink body part 100 in a way to come into surface contact with the mounting surface.

The other surface of the heat sink body part 100 may be a heat dissipation surface 102 to which the plurality of heat dissipation fin parts 200 that performs a heat dissipation action through the exchange of heat is fixed.

An example in which the heat dissipation surface 102 is a side opposite to the mounting surface 101 in the heat sink body part 100 is taken. In addition, the heat dissipation surface may be changed and practiced as a surface different from the mounting surface 101 depending on the design of a product.

The plurality of heat dissipation fin parts 200 may perform a heat dissipation action of discharging heat that is generated from the product to the outside of the heat sink body part 100. The plurality of heat dissipation fin parts 200 may each be formed in the form of a plate that is thinner than the heat sink body part 100. An upright length L1 of each of the plurality of heat dissipation fin parts 200 may be formed to be longer than a length L2 from the mounting surface 101 of the heat sink body part 100 to the heat dissipation surface 102. An example in which each of the plurality of heat dissipation fin parts 200 has a flat panel shape is taken. In addition, each of the plurality of heat dissipation fin parts may be manufactured in various shapes, such as a bent panel shape or a pole shape.

An example in which the heat sink body part 100 and the heat dissipation fin part 200 are each manufactured by using an aluminum material or an aluminum alloy material is taken. In addition, the heat sink body part and the heat dissipation fin part may each be manufactured by using various known materials having excellent heat conductivity for the manufacturing of the heat sink.

Furthermore, the heat sink body part 100 is manufactured in a pre-designed form by casting. An example in which the heat dissipation fin part 200 is manufactured by cutting, in a pre-designed size, an aluminum or aluminum alloy material that is manufactured in a flat straight-line form is taken.

A plurality of welding coupling parts 107 to which the plurality of heat dissipation fin parts 200 is coupled by laser welding, respectively, may be formed on the heat dissipation surface 102 of the heat sink body part 100 in a way to protrude therefrom.

However, the welding coupling parts 107 may not be formed on the heat dissipation surface 102 of the heat sink body part 100. In this case, the plurality of heat dissipation fin parts 200 may be disposed to be upright on the heat dissipation surface 102 of the heat sink body part 100 so that the plurality of heat dissipation fin parts is seated on the heat dissipation surface. The plurality of heat dissipation fin parts may be fixed on the heat dissipation surface 102 of the heat sink body part 100 through laser welding in the state in which the plurality of heat dissipation fin parts has been seated on the heat dissipation surface 102 of the heat sink body part 100.

The laser welding may fix the heat dissipation fin part 200 on the heat dissipation surface 102 of the heat sink body part 100 by the laser welding by radiating a laser to a boundary line of the heat sink body part 100 and the heat dissipation fin part 200, that is, an edge of the heat dissipation fin part 200 at one end thereof, which meets the heat dissipation surface 102, in the state in which the end of the heat dissipation fin part 200 has been seated on the heat dissipation surface 102 of the heat sink body part 100.

The thickness L3 of the start stage of a part that belongs to each of the plurality of welding coupling parts 107 and that protrudes from the heat dissipation surface 102 of the heat sink body part 100 may be formed to be smaller than the thickness L4 of an end in the protruding direction thereof.

Specifically, the plurality of welding coupling parts 107 may be formed to have a smaller width from the heat dissipation surface 102 of the heat sink body part 100 toward the end in the protruding direction. Accordingly, heat dissipation performance can be improved by narrowing a space between the plurality of heat dissipation fin parts 200 and installing a larger number of plurality of heat dissipation fin parts 200 in the heat dissipation surface 102 of the heat sink body part 100 because upon laser welding, the laser welding is possible even at a low laser radiation angle.

Referring to FIGS. 6 and 7, the plurality of welding coupling parts 107 may each be formed in round shapes R1 and R2 in which both sides of the start stage of the part that protrudes from the heat dissipation surface 102 of the heat sink body part 100 are concave. Furthermore, the plurality of welding coupling parts 107 may each be formed in round shapes R3 and R4 in which both sides of an end in a protruding direction thereof are convex. The curvature radii of the round shapes R1 and R2 may be identical with each other. The curvature radii of the round shapes R3 and R4 may be identical with each other. The curvature radius of each of the round shapes R1 and R2 may be formed to be greater than the curvature radius of each of the round shapes R3 and R4.

A welding coupling protrusion 210 that is coupled to the welding coupling part 107 by laser welding may be formed at the bottom of each of the plurality of heat dissipation fin parts 200. The welding coupling protrusion 210 may be formed to be thicker than the thickness t1 of each of the plurality of heat dissipation fin parts 200. The welding coupling protrusion 210 may be formed to protrude from the bottom of each of the plurality of heat dissipation fin parts 200 to both sides thereof.

Meanwhile, each of the plurality of welding coupling parts 107 may include a first heat dissipation fin support part 110, a second heat dissipation fin support part 120, and a support block part 130. However, the welding coupling part 107 may be formed of only the first heat dissipation fin support part 110, may be formed of only the first heat dissipation fin support part 110 and the second heat dissipation fin support part 120, and may be formed of only the support block part 130.

If each of the plurality of welding coupling parts 107 is formed of the first heat dissipation fin support part 110, the second heat dissipation fin support part 120, and the support block part 130, the support block part 130 may be formed on the heat dissipation surface 102 in a way to protrude therefrom. The first heat dissipation fin support part 110 and the second heat dissipation fin support part 120 may be formed at both ends of the support block part 130 thereon, respectively, so that the first heat dissipation fin support part and the second heat dissipation fin support part are spaced apart from each other and protrude from the support block part. That is, the first heat dissipation fin support part 110 may be formed at one end of the support block part 130 thereon so that the first heat dissipation fin support part protrudes from the support block part. The second heat dissipation fin support part 120 may be formed at the other end of the support block part 130 thereon so that the second heat dissipation fin support part is spaced apart from the first heat dissipation fin support part 110 and protrudes from the support block part.

In this case, the welding coupling protrusion 210 is inserted between the first heat dissipation fin support part 110 and the second heat dissipation fin support part 120, and may stand upright on the support block part 130. At least one side of the welding coupling protrusion 210 may be coupled to one side of at least one of the first heat dissipation fin support part 110 and the second heat dissipation fin support part 120 by laser welding.

Furthermore, one side of at least one of the first heat dissipation fin support part 110 and the second heat dissipation fin support part 120, and at least one side of the welding coupling protrusion 210 may each be formed in a convex round shapes R5, R6, R7, and R8. In this case, the convex round shapes R5, R6, R7, and R8 may each be a shape in which a laser can be radiated to each of the plurality of heat dissipation fin parts 200 at an angle of 3 to 7° upon laser welding.

If a laser can be radiated to each of the plurality of heat dissipation fin parts 200 at an angle smaller than 3° upon laser welding, the heat dissipation fin part 200 may not be firmly coupled to the first heat dissipation fin support part 110 because the thickness of the laser welding is small. If a laser can be radiated to each of the plurality of heat dissipation fin parts 200 at an angle greater than 7° upon laser welding, heat dissipation performance may be degraded because an interval between the plurality of heat dissipation fin parts 200 is widened and thus the number of plurality of heat dissipation fin parts 200 is reduced. Accordingly, it is preferred that each of the convex round shapes R5, R6, R7, and R8 is a shape in which a laser can be radiated at an angle of 3 to 7° upon laser welding.

If each of the plurality of welding coupling parts 107 is formed of only the first heat dissipation fin support part 110, the first heat dissipation fin support part 110 may be formed on the heat dissipation surface 102 in a way to protrude therefrom.

In this case, the welding coupling protrusion 210 may stand upright on the heat dissipation surface 102 on one side of the first heat dissipation fin support part 110. One side of the welding coupling protrusion 210 may be coupled to one side of the first heat dissipation fin support part 110 by laser welding.

Furthermore, one side of the first heat dissipation fin support part 110 and one side of the welding coupling protrusion 210 may be formed in the convex round shapes R5 and R7, respectively. In this case, the convex round shapes R5 and R7 may each be a shape in which a laser can be radiated to each of the plurality of heat dissipation fin parts 200 at an angle of 3 to 7° upon laser welding.

If a laser can be radiated to each of the plurality of heat dissipation fin parts 200 at an angle smaller than 3° upon laser welding, the heat dissipation fin parts 200 may not be firmly coupled to the first heat dissipation fin support part 110 because the thickness of the laser welding is small. If a laser can be radiated to each of the plurality of heat dissipation fin parts 200 at an angle greater than 7° upon laser welding, heat dissipation performance may be degraded because an interval between the plurality of heat dissipation fin parts 200 is widened and thus the number of plurality of heat dissipation fin parts 200 is reduced. Accordingly, it is preferred that the convex round shapes R5 and R7 are each a shape in which a laser can be radiated at an angle of 3 to 7° upon laser welding.

If each of the plurality of welding coupling parts 107 is formed of only the first heat dissipation fin support part 110 and the second heat dissipation fin support part 120, the first heat dissipation fin support part 110 and the second heat dissipation fin support part 120 may be formed on the heat dissipation surface 102 in a way to protrude therefrom.

In this case, the welding coupling protrusion 210 is inserted between the first heat dissipation fin support part 110 and the second heat dissipation fin support part 120, and may stand upright on the heat dissipation surface 102. At least one side of the welding coupling protrusion 210 may be coupled to one side of at least one of the first heat dissipation fin support part 110 and the second heat dissipation fin support part 120 by laser welding.

Furthermore, one side of at least one of the first heat dissipation fin support part 110 and the second heat dissipation fin support part 120 and at least one side of the welding coupling protrusion 210 may be formed in the convex round shapes R5, R6, R7, and R8. In this case, the convex round shapes R5, R6, R7, and R8 may each be a shape in which a laser can be radiated to each of the plurality of heat dissipation fin parts 200 at an angle of 3 to 7° upon laser welding.

If a laser can be radiated to each of the plurality of heat dissipation fin parts 200 at an angle smaller than 3° upon laser welding, the heat dissipation fin part 200 may not be firmly coupled to the first heat dissipation fin support part 110 because the thickness of the laser welding is small. If a laser can be radiated at an angle greater than 7° to each of the plurality of heat dissipation fin parts 200 upon laser welding, heat dissipation performance may be degraded because an interval between the plurality of heat dissipation fin parts 200 is widened and thus the number of plurality of heat dissipation fin parts 200 is reduced. Accordingly, it is preferred that each of the convex round shapes R5, R6, R7, and R8 is a shape in which a laser can be radiated at an angle of 3 to 7° upon laser welding.

If each of the plurality of welding coupling parts 107 is formed of only the support block part 130, the support block part 130 may be formed on the heat dissipation surface 102 in a way to protrude therefrom.

In this case, the welding coupling protrusion 210 may stand upright on the support block part 130. At least one side of the welding coupling protrusion 210 may be coupled to the support block part 130 by laser welding.

Furthermore, at least one side of the welding coupling protrusion 210 may be formed in the convex round shapes R7 and R8. In this case, the convex round shapes R7 and R8 may each be a shape in which a laser can be radiated to each of the plurality of heat dissipation fin parts 200 at an angle of 3 to 7° upon laser welding.

If a laser can be radiated to each of the plurality of heat dissipation fin parts 200 at an angle smaller than 3° upon laser welding, the heat dissipation fin part 200 may not be firmly coupled to the first heat dissipation fin support part 110 because the thickness of the laser welding is small. If a laser can be radiated to each of the plurality of heat dissipation fin parts 200 at an angle greater than 7° upon laser welding, heat dissipation performance may be degraded because an interval between the plurality of heat dissipation fin parts 200 is widened and thus the number of plurality of heat dissipation fin parts 200 is reduced. Accordingly, it is preferred that each of the convex round shapes R7 and R8 is a shape in which a laser can be radiated at an angle of 3 to 7° upon laser welding.

The curvature radii of the round shapes R5 and R6 may be identical with each other. The curvature radii of the round shapes R7 and R8 may be identical with each other. The curvature radius of each of the round shapes R5 and R6 may be identical with the curvature radius of each of the round shapes R3 and R4. The curvature radius of each of the round shapes R7 and R8 may be smaller than the curvature radius of each of the round shapes R5 and R6.

The first heat dissipation fin support part 110 and the second heat dissipation fin support part 120 are spaced apart from each other at an interval that is identical with or minutely greater than the thickness t1 of the heat dissipation fin part 200. Accordingly, the heat dissipation fin part 200 may be fit and inserted between the first heat dissipation fin support part 110 and the second heat dissipation fin support part 120.

The first heat dissipation fin support part 110 and the second heat dissipation fin support part 120 are spaced apart from each other at an interval that is 1 to 1.2 times the thickness t1 of the heat dissipation fin part 200. Accordingly, the heat dissipation fin part 200 may be fit and inserted between the first heat dissipation fin support part 110 and the second heat dissipation fin support part 120.

Furthermore, the thickness t2 of the first heat dissipation fin support part 110 and the thickness t3 of the second heat dissipation fin support part 120 may each be the same as or minutely greater or smaller than the thickness t1 of each of the plurality of heat dissipation fin parts 200. More specifically, each of the thickness t2 of the first heat dissipation fin support part 110 and the thickness t3 of the second heat dissipation fin support part 120 may be formed to be 0.7 to 1.1 times the thickness t1 of each of the plurality of heat dissipation fin parts 200.

The first heat dissipation fin support part 110 and the second heat dissipation fin support part 120 may play a role of increasing fixing power of the heat dissipation fin part 200 by supporting both sides of the heat dissipation fin part 200 that is fixed by laser welding, and may also play a role as filler metal upon laser welding.

One side of any one of the first heat dissipation fin support part 110 and the second heat dissipation fin support part 120 is melted upon laser welding and plays a role as filler metal. In this case, when each of the thickness t2 of the first heat dissipation fin support part 110 and the thickness t3 of the second heat dissipation fin support part 120 is greater than 1.1 times the thickness t1 of each of the plurality of heat dissipation fin parts 200, it is difficult for each of the thickness of the first heat dissipation fin support part and the thickness of the second heat dissipation fin support part to play a role as filler metal upon laser welding. When each of the thickness t2 of the first heat dissipation fin support part 110 and the thickness t3 of the second heat dissipation fin support part 120 is smaller than 0.7 times the thickness t1 of each of the plurality of heat dissipation fin parts 200, there is a problem in that stiffness that supports the heat dissipation fin part 200, that is, stiffness for a side opposite to a welding portion, is insufficient. Accordingly, it is preferred that each of the thickness t2 of the first heat dissipation fin support part 110 and the thickness t3 of the second heat dissipation fin support part 120 is formed to be 0.7 to 1.1 times the thickness t1 of each of the plurality of heat dissipation fin parts 200.

Furthermore, each of the height h of the first heat dissipation fin support part 110 and the height h of the second heat dissipation fin support part 120 may be formed to be 1 to 2 times the thickness t1 of each of the plurality of heat dissipation fin parts 200.

When each of the height h of the first heat dissipation fin support part 110 and the height h of the second heat dissipation fin support part 120 is smaller than the thickness t1 of each of the plurality of heat dissipation fin parts 200, stiffness that supports both sides of each of the plurality of heat dissipation fin parts 200 may be insufficient. When each of the height h of the first heat dissipation fin support part 110 and the height h of the second heat dissipation fin support part 120 is greater than 2 times the thickness t1 of each of the plurality of heat dissipation fin parts 200, it may become a cause that degrades a heat dissipation effect. Accordingly, it is preferred that each of the height h of the first heat dissipation fin support part 110 and the height h of the second heat dissipation fin support part 120 is formed to be 1 to 2 times the thickness t1 of each of the plurality of heat dissipation fin parts 200.

The support block part 130 may be formed on the heat dissipation surface 102 of the heat sink body part 100 in a way to protrude therefrom. The support block part 130 may connect the bottom of the first heat dissipation fin support part 110 and the bottom of the second heat dissipation fin support part 120, and the heat dissipation surface 102 of the heat sink body part 100. The first heat dissipation fin support part 110 and the second heat dissipation fin support part 120 may be formed at the ends of the support block part 130 thereon in a way to protrude therefrom.

A minimum thickness of the support block part 130 is formed to be 2.4 to 3.3 times the thickness t1 of each of the plurality of heat dissipation fin parts 200, and is a thickness at which the first heat dissipation fin support part 110 and the second heat dissipation fin support part 120 can be stably formed at the ends of the support block part 130 thereon. The minimum thickness of the support block part is a thickness that does not affect an interval between the plurality of heat dissipation fin parts 200.

That is, when the minimum thickness t4 of the support block part 130 is smaller than 2.4 times the thickness t1 of each of the plurality of heat dissipation fin parts 200, the thickness t2 of the first heat dissipation fin support part 110 and the thickness t3 of the second heat dissipation fin support part 120 cannot be sufficiently formed. When the thickness t4 of the support block part 130 is greater than 3.3 times the thickness t1 of each of the plurality of heat dissipation fin parts 200, there may be a problem in that heat dissipation performance is degraded because the number of plurality of heat dissipation fin parts 200 installed in the heat sink body part 100 is small. Accordingly, it is preferred that the thickness t4 of the support block part 130 is formed to be 2.4 to 3.3 times the thickness t1 of each of the plurality of heat dissipation fin parts 200.

The support block part 130 is disposed to isolate a corresponding heat dissipation fin part 200 from another heat dissipation fin part on the heat dissipation surface 102 of the heat sink body part 100, and allows a corresponding laser welding portion to be disposed at a pre-designed height or more on the heat dissipation surface 102 of the heat sink body part 100 in order to prevent a phenomenon in which the mounting surface 101 of the heat sink body part 100 is bent by heat after laser welding.

Any one of the first heat dissipation fin support part 110 and the second heat dissipation fin support part 120 plays a role as filler metal that is melted along with the heat dissipation fin part 200 upon laser welding. After the laser welding, the heat dissipation fin part 200 may be fixed between the first heat dissipation fin support part 110 and the second heat dissipation fin support part 120 through the laser welding.

After the heat dissipation fin part 200 is inserted between the first heat dissipation fin support part 110 and the second heat dissipation fin support part 120, laser welding is performed on one side of any one of the first heat dissipation fin support part 110 and the second heat dissipation fin support part 120. Accordingly, the heat dissipation fin part 200 can be firmly fixed between the first heat dissipation fin support part 110 and the second heat dissipation fin support part 120.

After the laser welding, the heat dissipation fin part 200 is supported by the first heat dissipation fin support part 110 and the second heat dissipation fin support part 120. Accordingly, the heat dissipation fin part can be firmly fixed on the heat dissipation surface 102 of the heat sink body part 100 because stiffness in both directions of the heat dissipation fin part is increased.

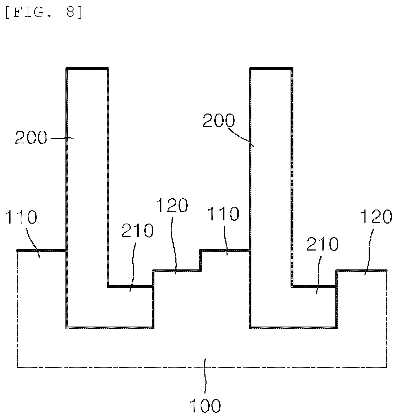

FIG. 8 is a diagram illustrating a heat sink structure according to another embodiment of the present disclosure.

Referring to FIG. 8, in the heat sink structure according to another embodiment of the present disclosure, a welding coupling protrusion 210 formed at the bottom of each of the plurality of heat dissipation fin parts 200 may be formed to protrude from the bottom of each of the plurality of heat dissipation fin parts 200 to one side thereof. In the present embodiment, the welding coupling protrusion 210 may be bent from the bottom of each of the plurality of heat dissipation fin parts 200 to one side thereof in a way to protrude therefrom. Accordingly, an overall shape of the heat dissipation fin part 200 and the welding coupling protrusion 210 may be an L shape.

Furthermore, in the heat sink structure according to another embodiment of the present disclosure, the heights of the first heat dissipation fin support part 110 and the second heat dissipation fin support part 120 may be differently formed. That is, the height of the first heat dissipation fin support part 110 may be formed to be higher than the height of the second heat dissipation fin support part 120. The height of the second heat dissipation fin support part 120 may be formed to be shorter than the height of the first heat dissipation fin support part 110.

Furthermore, the welding coupling protrusion 210 may be inserted between the first heat dissipation fin support part 110 and the second heat dissipation fin support part 120. One side of the welding coupling protrusion 210 may be coupled to one side of the second heat dissipation fin support part 120 by laser welding. One side of the bottom of the heat dissipation fin part 200, which is disposed on a side opposite to the welding coupling protrusion 210, may be supported by one side of the first heat dissipation fin support part 110.

Furthermore, the second heat dissipation fin support part 120 formed in any one welding coupling part 107 may be integrally formed with the first heat dissipation fin support part 110 formed in the welding coupling part 107 that is adjacent to the any one welding coupling part 107. However, the second heat dissipation fin support part 120 formed in the any one welding coupling part 107 may be formed to be spaced apart from the first heat dissipation fin support part 110 formed in the adjacent welding coupling part 107.

Meanwhile, a method of manufacturing the heat sink structure 1 according to the present disclosure may include a preparation step and a laser welding step.

In the preparation step, the heat sink body part 100 and the plurality of heat dissipation fin parts 200 may be separately manufactured.

The laser welding step may be performed after the preparation step. In the laser welding step, the plurality of heat dissipation fin parts 200 may be fixed to the heat dissipation surface 102 of the heat sink body part 100 by laser welding so that the plurality of heat dissipation fin parts is spaced apart from each other.

In the preparation step, the heat sink body part 100 may be manufactured by casting. The plurality of heat dissipation fin parts 200 may be manufactured by cutting a metal plate that has been previously manufactured. In this case, the metal plate that has been previously manufactured may be an aluminum plate or an aluminum alloy plate.

In the laser welding step, in the state in which each of the plurality of heat dissipation fin parts 200 has been made to stand upright and the bottom of each of the plurality of heat dissipation fin parts 200 has been seated on the heat dissipation surface 102, the heat dissipation fin part 200 may be fixed on the heat dissipation surface 102 by laser welding by slantly radiating a laser between one surface of each of the plurality of heat dissipation fin parts 200 and the heat dissipation surface 102.

Furthermore, in the preparation step, the plurality of welding coupling parts 107 may be formed on the heat dissipation surface 102 of the heat sink body part 100 in a way to protrude therefrom. The welding coupling protrusion 210 may be formed at the bottom of each of the plurality of heat dissipation fin parts 200. Furthermore, in the laser welding step, the welding coupling protrusion 210 may be coupled to each of the plurality of the welding coupling part 107 by laser welding.

Specifically, in the preparation step, the heat sink body part 100 is manufactured by casting, and the first heat dissipation fin support part 110 may be formed on the heat dissipation surface 102 of the heat sink body part 100 in a way to protrude therefrom. In this case, in the laser welding step, the welding coupling protrusion 210 may stand upright on the heat dissipation surface 102 on one side of the first heat dissipation fin support part 110, and one side of the welding coupling protrusion 210 may be coupled to one side of the first heat dissipation fin support part 110 by laser welding.

Alternatively, in the preparation step, the heat sink body part 100 is manufactured by casting, and the first heat dissipation fin support part 110 and the second heat dissipation fin support part 120 may be formed on the heat dissipation surface 102 of the heat sink body part 100 in a way to protrude therefrom so that the first heat dissipation fin support part and the second heat dissipation fin support part are spaced apart from each other. In this case, in the laser welding step, the welding coupling protrusion 210 is inserted between the first heat dissipation fin support part 110 and the second heat dissipation fin support part 120, and may stand upright on the heat dissipation surface 102. At least one side of the welding coupling protrusion 210 may be coupled to one side of at least one of the first heat dissipation fin support part 110 and the second heat dissipation fin support part 120 by laser welding.

Alternatively, in the preparation step, the heat sink body part 100 is manufactured by casting, and the support block part 130 may be formed on the heat dissipation surface 102 of the heat sink body part 100 in a way to protrude therefrom. In this case, in the laser welding step, the welding coupling protrusion 210 may stand upright on the support block part 130, and at least one side of the welding coupling protrusion 210 may be coupled to the support block part 130 by laser welding.

Alternatively, in the preparation step, the heat sink body part 100 is manufactured by casting, and the support block part 130 may be formed on the heat dissipation surface 102 of the heat sink body part 100 in a way to protrude therefrom. The first heat dissipation fin support part 110 may be formed at one end of the support block part 130 thereon in a way to protrude therefrom. The second heat dissipation fin support part 120 may be formed at the other end of the support block part 130 thereon in a way to protrude therefrom so that the second heat dissipation fin support part is spaced apart from the first heat dissipation fin support part 110. In this case, in the laser welding step, the welding coupling protrusion 210 is inserted between the first heat dissipation fin support part 110 and the second heat dissipation fin support part 120, and may stand upright on the support block part 130. At least one side of the welding coupling protrusion 210 may be coupled to one side of at least one of the first heat dissipation fin support part 110 and the second heat dissipation fin support part 120 by laser welding.

Meanwhile, the welding coupling protrusion 210 does not need to be necessarily formed at the bottom of each of the plurality of heat dissipation fin parts 200. That is, the welding coupling protrusion 210 may not be formed at the bottom of each of the plurality of heat dissipation fin parts 200. In this case, the bottom of each of the plurality of heat dissipation fin parts 200 may be directly coupled on the heat dissipation surface 102 by laser welding, and may be directly coupled to the welding coupling part 107 by laser welding.

For example, in the preparation step, the heat sink body part 100 is manufactured by casting, and the first heat dissipation fin support part 110 and the second heat dissipation fin support part 120 are manufactured on the heat dissipation surface 102 in a way to protrude therefrom. The laser welding step may include a heat dissipation fin assembly step of inserting the bottom of the heat dissipation fin part 200 between the first heat dissipation fin support part 110 and the second heat dissipation fin support part 120. The laser welding step may include a heat dissipation fin welding step of performing laser welding on the bottom of the heat dissipation fin part 200 by radiating a laser on one side of any one of the first heat dissipation fin support part 110 and the second heat dissipation fin support part 120 after the heat dissipation fin assembly step.

More specifically, in the heat dissipation fin welding step, the bottom of the heat dissipation fin part 200 may be fixed by laser welding by slantly radiating a laser either between the first heat dissipation fin support part 110 and the bottom of the heat dissipation fin part 200 or between the second heat dissipation fin support part 120 and the bottom of the heat dissipation fin part 200, or by slantly simultaneously radiating lasers between the first heat dissipation fin support part 110 and the bottom of the heat dissipation fin part 200 and between the second heat dissipation fin support part 120 and the bottom of the heat dissipation fin part 200.

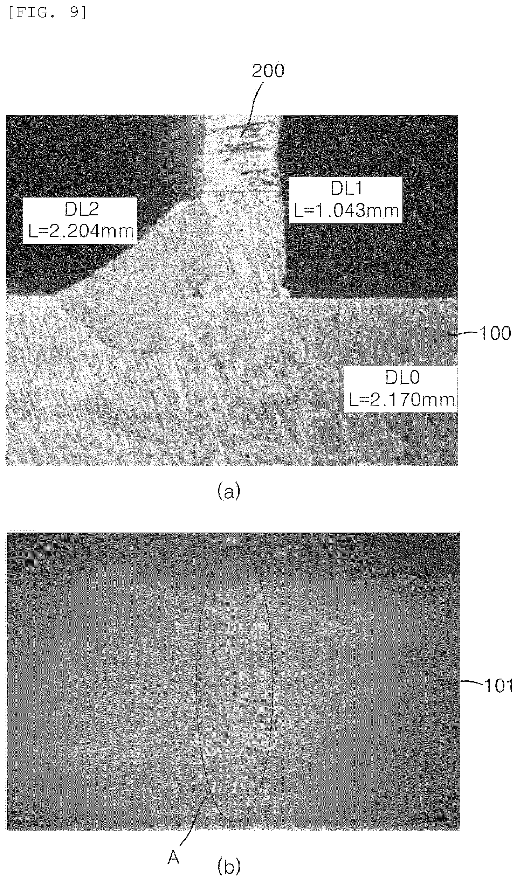

FIG. 9 is a photo of a first test example in which laser welding was performed on the heat dissipation fin part 200 in a method of manufacturing the heat sink structure 200 according to the present disclosure. In the first test example, a flat heat dissipation fin part 200 having a thickness of 1 mm was stood upright on the heat dissipation surface 102 of the heat sink body part 100 having a thickness of 2 mm, and fillet welding was performed.

Table 1 below illustrates laser welding condition in the first test example, and is an example in which laser welding was performed after the minimum amount of heat inputs (outputs) was set.

**[Table 1]**

| Wavelength | Mode | Power | Speed | Frequency | Wobble length |
|---|---|---|---|---|---|
| 1070 nm | Continuous wave | 900 w | 50 mm/s | 100 Hz | 1 mm |

FIG. 9 (a) is an enlarged photo of a welding portion. FIG. 9(b) is a photo of the bottom of the heat sink body part 100 after the welding.

Referring to FIG. 9(a), it may be seen that when one side of the heat dissipation fin part 200 was fixed by laser welding in the state in which the bottom of the flat heat dissipation fin part 200 having a thickness of 1 mm was directly seated on the heat dissipation surface 102 of the heat sink body part 100, the stiffness of a welding portion subjected to the laser welding was secured, but it was difficult to secure the stiffness of the heat dissipation fin part 200 on a side opposite to the welding portion.

In this case, the heat dissipation fin part 200 has a danger of being damaged during use because fixing power of the heat dissipation fin part is insufficient with respect to a force that is generated from the welding portion side to the side opposite to the welding portion. In order to prevent such a problem, there is inconvenience to perform laser welding on both sides of the heat dissipation fin part 200.

Furthermore, referring to FIG. 9(b), it may be seen that when laser welding was performed on one side of the heat dissipation fin part 200 in the state in which the bottom of the flat heat dissipation fin part 200 having a thickness of 1 mm was directly seated on the heat dissipation surface 102 of the heat sink body part 100, bending deformation occurred in the mounting surface 101, that is, the bottom of the heat sink body part 100, within a dotted portion indicated by reference numeral A although the laser welding was performed after minimum heat inputs (outputs) are set.

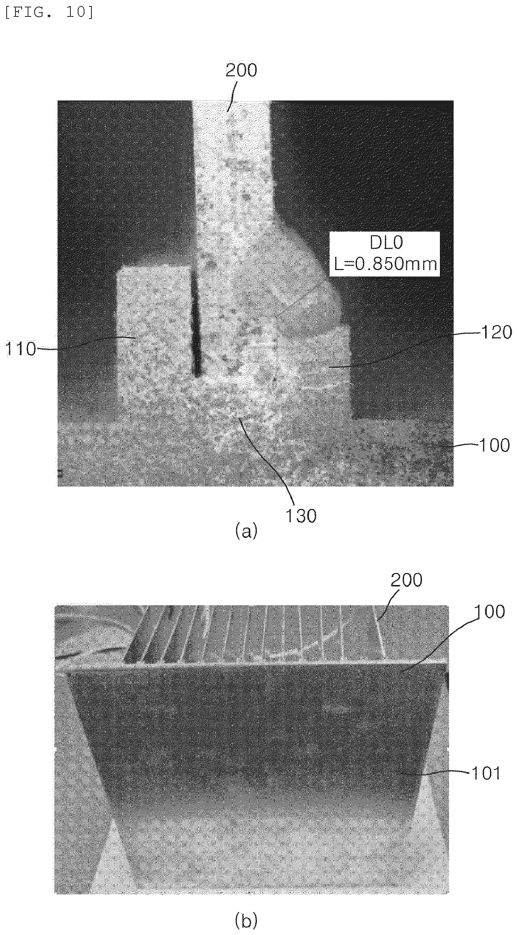

FIG. 10 is a photo of a second test example in which laser welding was performed on the heat dissipation fin part 200 in a method of manufacturing a heat sink structure according to the present disclosure. In the second test example, the support block part 130 protruded on the heat dissipation surface of the heat sink body part 100 of 2 mm. The first heat dissipation fin support part 110 and the second heat dissipation fin support part 120 each having a thickness of 1 mm protruded on the support block part 130. The bottom of a flat heat dissipation fin part 200 having a thickness of 1 mm was inserted between the first heat dissipation fin support part 110 and the second heat dissipation fin support part 120. Fillet welding was performed on by slantly radiating a laser between the second heat dissipation fin support part 120 and the heat dissipation fin part 200.

Table 2 below illustrates laser welding condition in the second test example, and is an example in which laser welding was performed after the amount of heat inputs (outputs) greater than those of the first test example were set.

**[Table 2]**

| Wavelength | Mode | Power | Speed | Frequency | Wobble length |
|---|---|---|---|---|---|
| 1070 nm | Continuous wave | 1250 w | 70 mm/s | 200 Hz | 0.4 mm |

FIG. 10(a) is an enlarged photo of a welding portion. FIG. 10(b) is a photo of the bottom of the heat sink body part 100 after the welding.

Referring to FIG. 10(a), it may be seen that the first heat dissipation fin support part 110 reinforced stiffness on a side opposite to the laser welding portion by supporting one side of the heat dissipation fin part 200 on which the laser welding was not performed, a part of an upper part of the second heat dissipation fin support part 120 was welded upon laser welding and played a role as filler metal and also further increased the stiffness of the laser welding portion. Furthermore, referring to FIG. 10(b), it may be seen that bending deformation did not occur in the mounting surface 101, that is, the bottom of the heat sink body part 100.

As described above, in the heat sink structure 1 and the method of manufacturing the same according to an embodiment of the present disclosure, after the heat sink body part 100 and the plurality of heat dissipation fin parts 200 are separately manufactured, the plurality of heat dissipation fin parts 200 is fixed to the heat sink body part 100 by laser welding. Accordingly, heat dissipation efficiency can be improved by securing a sufficient heat dissipation surface because each of the plurality of heat dissipation fin parts 200 is formed in a plate shape that is thin and long compared to the heat sink body part 100.

Furthermore, in the heat sink structure 1 and the method of manufacturing the same according to an embodiment of the present disclosure, after the heat sink body part 100 and the plurality of heat dissipation fin parts 200 are separately manufactured, the plurality of heat dissipation fin parts 200 is fixed to the heat sink body part 100 by laser welding. Accordingly, the thickness of each of the plurality of heat dissipation fin parts 200 and an interval between the heat dissipation fin parts can be minimized, and a manufacturing cost can be greatly reduced.

A person having ordinary knowledge in the art to which the present disclosure pertains will understand that the present disclosure may be implemented in other detailed forms without changing the technical spirit or essential characteristics of the present disclosure. Accordingly, the aforementioned embodiments should be construed as being only illustrative, but should not be construed as being restrictive from all aspects. The scope of the present disclosure is defined by the appended claims rather than by the detailed description, and all changes or modifications derived from the meanings and scope of the claims and equivalent concepts thereof should be interpreted as being included in the scope of the present disclosure.

### [Industrial Applicability]

The present disclosure provides the heat sink structure having improved heat dissipation efficiency by securing a sufficient heat dissipation surface in a way that after the heat sink body part and the plurality of heat dissipation fin parts are separately manufactured, the plurality of heat dissipation fin parts is fixed to the heat sink body part by laser welding so that each of the plurality of heat dissipation fin parts is formed in a plate shape that is thin and long compared to the heat sink body part, and the method of manufacturing the same.

## Claims

1. A heat sink structure comprising:
a heat sink body part comprising a mounting surface on which a product that is a heat dissipation target is placed on one surface thereof and comprising a heat dissipation surface for discharging heat on a surface different from the one surface; and
a plurality of heat dissipation fin parts configured to stand upright on the heat dissipation surface of the heat sink body part and coupled thereto by laser welding.

2. The heat sink structure of claim 1, wherein a plurality of welding coupling parts to which the plurality of heat dissipation fin parts is coupled by laser welding, respectively, is formed in the heat dissipation surface of the heat sink body part in a way to protrude therefrom.

3. The heat sink structure of claim 2, wherein a welding coupling protrusion coupled to each of the plurality of welding coupling parts by laser welding is formed to be thicker than a thickness of each of the plurality of heat dissipation fin parts at a bottom of each of the plurality of heat dissipation fin parts.

4. The heat sink structure of claim 2, wherein each of the plurality of welding coupling parts is formed in round shapes in which both sides of a start stage of a part that belongs to each of the plurality of welding coupling parts and that protrudes from the heat dissipation surface of the heat sink body part are concave, and is formed in round shapes in which both sides of an end in a protruding direction thereof are convex.

5. The heat sink structure of claim 3, wherein:
each of the plurality of welding coupling parts comprises a first heat dissipation fin support part formed on the heat dissipation surface in a way to protrude therefrom, and
the welding coupling protrusion stands upright on the heat dissipation surface on one side of the first heat dissipation fin support part, and one side of the welding coupling protrusion is coupled to one side of the first heat dissipation fin support part by laser welding.

6. The heat sink structure of claim 3, wherein:
each of the plurality of welding coupling parts comprises a first heat dissipation fin support part and a second heat dissipation fin support part formed on the heat dissipation surface in a way to protrude therefrom,
the welding coupling protrusion is inserted between the first heat dissipation fin support part and the second heat dissipation fin support part and stands upright on the heat dissipation surface, and
at least one side of the welding coupling protrusion is coupled to one side of at least one of the first heat dissipation fin support part and the second heat dissipation fin support part by laser welding.

7. The heat sink structure of claim 3, wherein:
each of the plurality of welding coupling parts comprises a support block part formed on the heat dissipation surface in a way to protrude therefrom,
the welding coupling protrusion stands upright on the support block part, and
at least one side of the welding coupling protrusion is coupled to the support block part by laser welding.

8. The heat sink structure of claim 3, wherein each of the plurality of welding coupling parts comprises:
a support block part formed on the heat dissipation surface in a way to protrude therefrom;
a first heat dissipation fin support part formed at one end of the support block part thereon in a way to protrude therefrom; and
a second heat dissipation fin support part formed at the other end of the support block part thereon in a way to protrude therefrom so that the second heat dissipation fin support part is spaced apart from the first heat dissipation fin support part,
wherein the welding coupling protrusion is inserted between the first heat dissipation fin support part and the second heat dissipation fin support part and stands upright on the support block part, and
at least one side of the welding coupling protrusion is coupled to one side of at least one of the first heat dissipation fin support part and the second heat dissipation fin support part by laser welding.

9. The heat sink structure of claim 5, wherein one side of the first heat dissipation fin support part and one side of the welding coupling protrusion are each formed in a convex round shape.

10. The heat sink structure of claim 6, wherein one side of at least one of the first heat dissipation fin support part and the second heat dissipation fin support part and at least one side of the welding coupling protrusion are each formed in a convex round shape.

11. The heat sink structure of claim 7, wherein at least one side of the welding coupling protrusion is formed in a convex round shape.

12. The heat sink structure of claim 8, wherein one side of at least one of the first heat dissipation fin support part and the second heat dissipation fin support part and at least one side of the welding coupling protrusion are each formed in a convex round shape.

13. The heat sink structure according to any one of claims 9 to 12, wherein the convex round shape is a shape in which a laser is able to be radiated to each of the plurality of heat dissipation fin parts at an angle of 3 to 7° upon laser welding.

14. The heat sink structure of claim 5, wherein:
a thickness of the first heat dissipation fin support part is formed to be 0.7 to 1.1 times a thickness of each of the plurality of heat dissipation fin parts, and
a height of the first heat dissipation fin support part is formed to be 1 to 2 times the thickness of each of the plurality of heat dissipation fin parts.

15. The heat sink structure of claim 6, wherein:
each of a thickness of the first heat dissipation fin support part and a thickness of the second heat dissipation fin support part is formed to be 0.7 to 1.1 times a thickness of each of the plurality of heat dissipation fin parts, and
each of a height of the first heat dissipation fin support part and a height of the second heat dissipation fin support part is formed to be 1 to 2 times the thickness of each of the plurality of heat dissipation fin parts.

16. The heat sink structure of claim 7, wherein a minimum thickness of the support block part is formed to be 2.4 to 3.3 times a thickness of each of the plurality of heat dissipation fin parts.

17. The heat sink structure of claim 8, wherein:
each of a thickness of the first heat dissipation fin support part and a thickness of the second heat dissipation fin support part is formed to be 0.7 to 1.1 times a thickness of each of the plurality of heat dissipation fin parts,
each of a height of the first heat dissipation fin support part and a height of the second heat dissipation fin support part is formed to be 1 to 2 times the thickness of each of the plurality of heat dissipation fin parts, and
a minimum thickness of the support block part is formed to be 2.4 to 3.3 times the thickness of each of the plurality of heat dissipation fin parts.

18. A method of manufacturing a heat sink structure, the method comprising:
a preparation step of separately manufacturing a heat sink body part comprising a mounting surface on which a product that is a heat dissipation target is placed on one surface thereof and comprising a heat dissipation surface for discharging heat on a surface different from the one surface and a plurality of heat dissipation fin parts that performs a heat dissipation action; and
a laser welding step of fixing the plurality of heat dissipation fin parts to the heat dissipation surface of the heat sink body part by laser welding so that the plurality of heat dissipation fin parts is spaced apart from each other.

19. The method of claim 18, wherein in the preparation step, the heat sink body part is manufactured by casting, and the plurality of heat dissipation fin parts is manufactured by cutting a metal plate that has been previously manufactured.

20. The method of claim 18, wherein:
in the preparation step, a plurality of welding coupling parts is formed in the heat dissipation surface of the heat sink body part in a way to protrude therefrom, and a welding coupling protrusion thicker than a thickness of each of the plurality of heat dissipation fin parts is formed at a bottom of each of the plurality of heat dissipation fin parts, and
in the laser welding step, the welding coupling protrusion is coupled to each of the plurality of welding coupling parts by laser welding.
